(19) Europäisches Patentamt
European Patent Office
Office européen des brevets

(11) Publication number : **0 402 028 B1**

# (12) EUROPEAN PATENT SPECIFICATION

(45) Date of publication of patent specification : **01.02.95 Bulletin 95/05**

(51) Int. Cl.[6] : **H05K 3/02**, H05K 3/38, H05K 1/03

(21) Application number : **90305843.6**

(22) Date of filing : **30.05.90**

## (54) Process for producing boards for precision fine-line circuits.

(30) Priority : **06.06.89 JP 143464/89**

(43) Date of publication of application : **12.12.90 Bulletin 90/50**

(45) Publication of the grant of the patent : **01.02.95 Bulletin 95/05**

(84) Designated Contracting States : **AT BE CH DE DK ES FR GB GR IT LI LU NL SE**

(56) References cited :
**EP-A- 0 305 846**
**US-A- 2 740 732**
**US-A- 3 668 300**
**PATENT ABSTRACTS OF JAPAN, vol. 11, no. 246 (C-439)[2693], 11th August 1987; & JP-A-62 54 073**

(73) Proprietor : **POLYPLASTICS CO. LTD.**
**3-13, Azuchicho, 2-chome**
**Chuo-Ku Osaka-shi Osaka 541 (JP)**

(72) Inventor : **Suzuki, Yoshiharu**
**3-3-1, B 201 Shinmatsudo**
**Matsudo-shi, Chiba (JP)**
Inventor : **Akeda, Tomoyuki**
**885-11, Miyajima**
**Fuji-shi, Shizuoka (JP)**

(74) Representative : **Jackson, Peter et al**
**HYDE, HEIDE & O'DONNELL**
**10-12 Priests Bridge**
**London SW15 5JE (GB)**

EP 0 402 028 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a process of forming a metallic coating on the surface of a base plate which is prepared by molding a resin composition comprising a melt processable polyester capable of forming as anisotropic molten phase (hereinafter referred to as "liquid-crystal polyester") and which gives a board suitable for the formation of a precision fine-line circuit by the subtractive method.

In particular, the present invention relates to a process for producing a board suitable for the formation of a precision fine-line circuit by the substractive method, wherein a base plate prepared by molding a liquid-crystal polyester resin composition having excellent heat resistance and moldability can be efficiently coated to form a metallic coating on the surface thereof.

Liquid-crystal polyesters are rigid polymers, unlike well-known thermoplastic polyesters such as polybutylene terphthalate or polyethylene terephthalate. Their molecular chains are difficult to bend and keep their rod-like shapes even in a molten state. Therefore, the molecules are entangled with each other only to a small extent even in the molten state and are oriented in one direction by even a slight shearing force. They are thus crystalline even in the liquid form, namely, they are liquid crystals.

Although liquid-crystal polyesters can be molded by an ordinary injection molding process and have excellent moldability, heat resistance and dimensional stability, they have a defect in that the surface layer of a base plate prepared by molding them peels off to cause a fuzzing due to their strong orientation. Thus they have not hitherto been successfully subjected to a secondary processing such as vacuum deposition, ion plating or sputtering.

Although it might be thought possible to roughen the surface of a liquid-crystal polyester by pretreatment with a chemical used for treating ordinary resins, the surface of the molding thus prepared is chemically quite inert and has no affinity with any solvent. Thus it is impossible to roughen the surface by removing the oriented surface layer. Another method of surface roughening comprises adding either an inorganic filler for weakening the strong orientation of the liquid-crystal polyester resin or an additive which can be easily leached and treating the resulting resin with a strongly acidic or strongly alkaline solution. However, a higher surface roughness is necessary to obtain a higher adhesion even when a metallic coating is formed by, for example, an electroless plating on the entire surface of the base plate thus etched. In this case the contours of the resist ink for forming a circuit pattern become unclear or the ink is attached to only part of the surface because of the unevenness of the surface of a base plate entirely coated with the metal, and in a pattern sticking method, the adhesion of a pattern-forming dry film to the base plate is poor. Since the thickness of the metallic coating formed on a highly rough surface is uneven, it is difficult to form a precision fine-line circuit from the coating by the substractive method.

In the process known from Patent Abstracts of Japan, vol. 11, no. 246 (C-439)[2693], 11th August 1987, a resin exhibiting optical anisotropy in the molten state is molded, subjected to surface roughening by an etching treatment, and then provided with a metallic layer by sputtering, plating or vapour deposition.

When a metallic coating is directly formed by vacuum deposition, sputtering or ion plating on a base plate improved in orientation but otherwise unimproved the adhesion of the coating is poor, though a smooth surface can be obtained. Thus this process is impractical. Particularly when an ordinary thermoplastic resin is subjected to vacuum deposition, sputtering or ion plating, a gas is generated in too large an amount from the raw material in vacuo to allow a high quality metallic coating to adhere firmly to the resin. Although liquid-crystal polyesters are substantially free from this gas-formation problem, no metallic coating can be firmly adhered thereto for the above described reasons. Even when a precision fine-line circuit is to be formed by the substractive method on a board prepared by adding an inorganic filler readily soluble in an acid or alkali to the resin, etching the resulting resin with the acid or alkali and subjecting the etched resin to an ordinary electroless plating to form a metallic coating on the entire surface, the minimum possible line width is 0.30mm and the minimum possible space width is 0.30mm in a circuit produced by the conventional process. In addition when the surface roughness is improved in order to increase the fineness of the lines, the adhesion of the coating film thereto is reduced impracticably.

The terms "line width" and "space width" as used herein refer to the width of each line of the circuit and the space between the lines adjacent to each other, respectively.

Liquid-crystal polyesters have features such as a low coefficient of linear expansion comparable to the coefficient of thermal linear expansion of an ordinary metal and a thermal resistance which causes no problems even when dipped in a soldering bath at 260°C for 10 sec. Although investigations have been made for the purpose of developing a process for coating the surface of base plate with a metal in order to improve the above-described surface properties and to produce parts joined to a metal with an adhesive or a base plate plated with a metal, taking advantage of these properties of the liquid-crystal polyester, no satisfactory process has hitherto been found.

The present invention arose from investigations into producing a board suitable for forming a precision fine-line circuit by the substractive method by forming a metallic coating closely adherent to the surface without impairing the physical and chemical properties of the liquid-crystal polyester and also without forming and easily peelable surface layer, taking advantage of the advantageous thermal properties of the liquid-crystal polyester. The inventors have found that a firmly adherent metallic coating can be formed on the surface of a molding made of a composition comprising a liquid-crystal polyester and an inorganic filler added thereto when the molding is surface-treated by sputtering, ion plating or vacuum deposition while degassing the molding by heating to a particular temperature in a vacuum tank and keeping the hardness of the surface layer as low as possible. By this process, a better precision fine-line circuit than that produced by a conventional process can be obtained according to the substractive method. The present invention has been completed on the basis of this finding.

Thus the present invention provides a process for producing a metal-coated board suitable for the formation of a precision fine-line circuit by the substractive method, wherein a base plate of said board is prepared by molding a melt-processable liquid-crystal polyester resin composition containing an inorganic filler, and a metal surface coating is applied directly to the molded base plate by sputtering ion plating or vacuum deposition while heating the surface of said plate to a temperature of 60°C to 270°C in a reduced-pressure chamber.

The substractive method for forming a circuit herein comprises coating or laminating the entire surface of a board with a conductive material such as a metal, coating with acid-proof material serving as an etching-resist those parts of the conductive material surface which are necessary for forming a conductor pattern based on the circuit design, dissolving in an etching solution, in which the metal is soluble, the metal in the conductor pattern-free parts which are not coated with any etching-resist and peeling off the etching resist with a chemical to expose the conductor pattern, thus forming a circuit.

The inorganic filler used in the process of the present invention is preferably one or more finely pulverised inorganic fillers selected from the group consisting of the Group II elements of the periodic table and their oxides, sulphates, phosphates, silicates and carbonates or the group consisting of aluminium, silicon, tin, lead, antimony and bismuth elements and their oxides. Particularly preferred inorganic fillers are one or more finely pulverised inorganic fillers selected from the group consisting of oxides, sulphates, phosphates and silicates of the Group II elements of the periodic table.

The oxides of the Group II elements of the periodic table include magnesium oxide, calcium oxide, barium oxide and zinc oxide. The phosphates include magnesium phosphate, calcium phosphate, barium phosphate, zinc phosphate, magnesium phosphate and calcium pyrophosphate. The sulphates include magnesium, calcium and barium sulphates. The silicates include magnesium silicate, calcium silicate, aluminium silicate, kaolin, talc, clay, diatomaceous earth and wollastonite. Among them, the phosphates are preferred. In addition, one or more substances selected from the group consisting of aluminium, silicon, tin, lead, antimony and bismuth and their oxides are also preferred. Particularly, metals such as zinc, aluminium, tin and lead and oxides of them are preferred.

The amount of the finely pulverized inorganic filler is 5 to 80% by weight, preferably 20 to 70% by weight, based on the whole liquid-crystal polyester resin composition. If it is less than 5% by weight, nonuniform flow marks are formed on the surface of the molding and a thin film formed on the surface is easily peeled off the molding when an adhesive tape is applied to the surface and then stripped. If, on the other hand, it exceeds 80% by weight then the fluidity of the resin is reduced and the obtained molding has a poor surface condition and reduced mechanical strength. The inorganic filler is preferably in the form of a fine powder and its average particle diameter is 0.01 to 100μm, preferably 0.1 to 30μm and most preferably 0.5 to 10μm. When the average particle diameter is less than 0.01μm, lumps tend to be formed on the surface of the molding due to an insufficient dispersion and, on the contrary, when it exceeds 100μm, the molding has such a poor surface smoothness that the formation of fine lines for a precision circuit becomes extremely difficult and no good appearance can be obtained.

Fibrous inorganic materials are also conveniently used as the inorganic filler. They can be used either singly or in combination with the above-described finely pulverised inorganic filler.

The fibrous inorganic fillers include fibers of glass, milled glass, carbon, asbestos, silica, silica/alumina, alumia, zirconia, boron nitride, silicon nitride, boron, potassium titanate and metals such as stainless steel, aluminium, titanium, copper and brass. They are used in an amount ranging from 1 to 60% by weight, preferably 5 to 40% by weight, based on the total composition for the molding. Preferably they have a diameter of 1 to 30μm and a length of 5μm to 1mm, particularly 10 to 100μm.

The preferred fibrous inorganic fillers are glass fiber, milled glass fiber and potassium titanate fiber. Glass fiber is particularly preferred. It has been unexpectedly found that when the glass fiber is used in combination with the above-described finely pulverised inorganic filler, the surface of the molding becomes more uniform and the adhesion of a metallic coating forming a conductive circuit to the molding is further improved. Milled

glass fiber is ranked between glass fiber and finely pulverised glass from the viewpoint of the balance between the surface roughness and the mechanical properties of the material.

From the viewpoints of the moldability and physical properties it is preferred that the total amount of the fibrous inorganic filler and the pulverised inorganic filler does not exceed 85% by weight based on the total weight of the composition for forming a molding.

The term "treatment of the surface to form a metallic coating" as used herein means a dry metal coating process to be conducted under a reduced pressure. In particular, it means a process wherein a metallic coating is directly formed on a base plate make of a resin molding by any of sputtering, ion plating and vacuum deposition. It is indispensable in the present invention to heat the resin molding to a temperature of 60°C or above, desirably 150°C or above. The upper limit of the temperature is, however, 270°C so as to avoid softening and deformation of the molding.

The preferred temperature is variable depending on the process for the treatment of the surface to form a metallic coating. In the sputtering process it ranges from 150°C to 250°C; in the ion plating process it ranges from 60°C to 200°C, and in the vacuum deposition process it ranges from 200°C to 250°C.

The base plate is preferably molded by a molding means selected from among injection molding, extrusion molding and compression molding.

The liquid-crystal polyester used in the process of the present invention is characterized in the amount of a gas generated from it in a reduced pressure chamber is smaller than that generated from other materials. Although a thin metallic coating firmly adherent to the resin surface can be prepared merely by sputtering, ion plating or vacuum deposition, the gas thus generated from the resin molding can be eliminated by heating and the hardness of the surface is reduced at the elevated temperature to improve further the adhesion of the metal atoms to the resin surface. The surface treatment with the metal is desirably conducted under a reduced pressure of 13.3 μPa to 133 mPa ($10^{-3}$ to $10^{-7}$ Torr). In the cases of ion plating or vacuum deposition the reduced pressure is more desirably 13.3 μPa to 1.33 mPa ($10^{-5}$ to $10^{-7}$ Torr).

Although the minimum possible line width and minimum possible space width of the conventional circuit were both 0.30mm as described above, both of them can be reduced to 0.25mm or below by the process of the present invention for the surface treatment with the metal. Further according to the process of the present invention, the circuit has a high adhesion and a precision fine-line circuit can be produced by the substractive method.

The liquid-crystal polyester used in the process of the present invention is a melt-processable polyester. Its molecular chains are regularly arranged in parallel in a molten state. Such an arranged state of the molecules is called a liquid crystal or a nematic phase of a liquid-crystal substance. These polymer molecules are usually slender and flat and have a considerably high rigidity along the major axes of the molecules. The polymer usually has chain-extending linkages which are coaxial or in parallel.

The properties of the anisotropic molten phase can be confirmed by an ordinary polarimetric method using crossed nicols. In particular, the anisotropic molten phase can be confirmed by observing a molten sample thereof placed on a Leitz hot stage of a Leitz polarizing microscope at x40 magnification in a nitrogen atmosphere. The polymer of the present invention transmits polarized light even in a molten static state when it is inspected between crossed nicols, i.e., it is optically anisotropic.

The liquid-crystal polymers suitably used in the process of the present invention are substantially insoluble in an ordinary solvent and, therefore, unsuitable for the solution processing. However, these polymers can be easily worked by an ordinary melt processing method as described above.

Preferred polymers capable of forming an anisotropic molten phase used in the present invention are not only aromatic polyesters and aromatic polyesteramides but also polyesters partially comprising an aromatic polyester and an aromatic polyesteramide in the same molecular chain.

Particularly preferred are liquid-crystal aromatic polyesters and liquid-crystal aromatic polyesteramides comprising as a constituent at least one compound selected from the group consisting of aromatic hydroxy carboxylic acids, aromatic hydroxy amines and aromatic diamines.

In particular, the polymers used in the process of the present invention include:

1) polymers mainly comprising one or more compounds selected from the group consisting of aromatic hydroxy carboxylic acids and derivatives thereof,

2) polyester mainly comprising:

a) one or more compounds selected from the group consisting of aromatic hydroxy carboxylic acids and derivatives thereof,

b) one or more compounds selected from the group consisting of aromatic dicarboxylic acids, alicyclic dicarboxylic acids and derivatives thereof, and

c) one or more compounds selected from the group consisting of aromatic diols, alicyclic diols, aliphatic diols and derivatives thereof,

3) polyesteramides mainly comprising:

a) one or more compounds selected from the group consisting of aromatic hydroxy carboxylic acids and derivatives thereof,

b) one or more compounds selected from the group consisting of aromatic hydroxy amines, aromatic diamines and derivatives thereof, and

c) one or more compounds selected from the group consisting of aromatic dicarboxylic acids, alicyclic dicarboxylic acids and derivatives thereof, and

4) polyesteramides mainly comprising:

a) one or more compounds selected from the group consisting of aromatic hydroxy carboxylic acids and derivatives thereof,

b) one or more compounds selected from the group consisting of aromatic hydroxy amines, aromatic diamines and derivatives thereof,

c) one or more compounds selected from the group consisting of aromatic dicarboxylic acids, alicyclic dicarboxylic acids and derivatives thereof, and

d) one or more compounds selected from the group consisting of aromatic diols, alicyclic diols, aliphatic diols and derivatives thereof.

If necessary, a molecular weight modifier can be used in combination with the above-described constituents.

Preferred examples of the compounds constituting the liquid-crystal polyesters of the present invention include naphthalene compounds such as 2,6-naphthalene-dicarboxylic acid, 2,6-dihydroxynaphthalene, 1,4-dihydroxynaphthalene and 6-hydroxy-2-naphthoic acid; biphenyl compounds such as 4,4′-diphenyldicarboxylic acid and 4,4′-dihydroxybiphenyl; compounds represented by the following formula general formulae (I), (II) or (III):

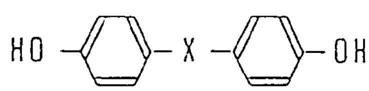

( I )

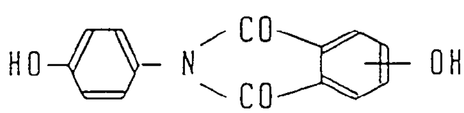

( II )

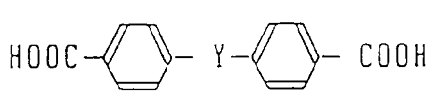

( III )

wherein X represents an alkylene group having 1 to 4 carbon atoms, an alkylidene group, -O-, -SO-, $-SO_2$, -S- or -CO-, and Y represents $-(CH_2)-$ in which n is 1 to 4 or $-O(CH_2)_nO-$ in which n is 1 to 4;
p-substituted benzene compounds such as p-hydroxy-benzoic acid, terephthalic acid, hydroquinone, p-aminiphenol and p-phenylenediamine each having a nucleus which may be substituted which a chlorine, bromine, methyl, phenyl or 1-phenylethyl group; and m-substituted benzene compounds such as isophthalic acid and resorcinol.

The liquid-crystal polyester used in the process of the present invention may comprise, in addition to the above-described constituents, a polyalkylene terephthalate which does not form any anisotropic molten phase in the same molecular chain. The alkyl group of the polyalkylene terephthalate has 2 to 4 carbon atoms.

Among the above-described constituents, one or more compounds selected from the group consisting of the naphthalene compounds, biphenyl compounds and p-substituted benzene compounds are preferably used as the indispensible constituents. Among the p-substituted benzene compounds, particularly preferred are p-hydroxybenzoic acid, methylhydroquinone and 1-phenylethylhydroquinone.

Examples of the compounds having ester-forming functional groups as the constituent and polyesters capable of forming an anisotropic molten phase preferably used in the process of the present invention are described in Japanese Patent Publication No. 36633/1988.

The liquid-crystal polyesters preferably used in the process of the present invention have usually a weight-average molecular weight of about 2,000 to 200,000, preferably about 10,000 to 50,000 and particularly preferably about 20,000 to 25,000. The preferred aromatic polyesteramides have a molecular weight of usually

about 5,000 to 50,000, preferably about 10,000 to 30,000, for example, 15,000 to 17,000.

The molecular weight can be determined by gel permeation chromatographor another standard method wherein no polymer solution is formed, such as infrared spectrophotometry wherein the terminal group of a compression-molded film is determined. In another method of determining the molecular weight, the molecular weight is determined by dissolving the sample in pentafluorophenol by the light scattering method.

A 0.1 wt.% solution prepared by dissolving the aromatic polyester or polyesteramide in pentafluorophenol at 60°C has usually an inherent viscosity (I.V.) of at least about 2.0 dl/g, for example, about 2.0 to 10.0dl/g.

In the present invention, the above-described inorganic fillers (finely pulverised inorganic filler and fibrous inorganic material) can be used in combination with various inorganic substances in order to improve the properties of the product. These inorganic substances are preferably used to form a board having excellent mechanical properties, thermal resistance and dimensional stability (resistance to deformation and warping). The inorganic substances used may be powdery, granular or platy depending on the purpose.

The powdery or granular inorganic substances include carbon black, graphite, silica, quartz powder, glass beads, glass balloons, glass powder, metal oxides such as iron oxides, ferrite, silicon carbide, silicon nitride and boron nitride.

The platy inorganic substances include mica, glass flake and various metal foils.

These inorganic substances to be used in combination with the inorganic filler are used either alone or in combination of two or more of them. If desired the inorganic filler and inorganic substance can be used in combination with a binder or surface treatment.

From the viewpoints of the moldability and physical properties it is preferred that the total amount of the inorganic filler and the inorganic substance does not exceed 85% by weight based on the total weight of the composition for forming a molding.

Another thermoplastic resin can be incorporated into the composition so far as the object of the invention is not hindered.

The thermoplastic resins usable herein are not particularly limited. They include polyolefins such as polyethylene and polypropylene, polyacetals (homopolymers and copolymers), polystyrene, polyvinyl chloride, polyacrylic esters and copolymers of them, polyamides, polycarbonates, ABS, polyphenylene oxides, polyphenylene sulphides and fluororesins. The thermoplastic resins can be used either alone or in the form of a mixture of two or more of them.

The resin composition may further contain known additives usually added to thermoplastic and thermosetting resins such as plasticizers, stabilizers (such as antioxidants or ultraviolet absorbers), antistatic agents, surface treatment agents, surfactants, flame retardants, colorants (such as dyes or pigments), lubricants for improving the fluidity and releasability and crystallization promoters (nucleating agents) depending on the required properties.

Boards produced according to the process of the present invention are well suited to use in forming a pin grid array (PGA) or as a molded board for printed wiring. They can conveniently be in the form of a cube, film or sheet.

As described above, according to the process of the present invention for the surface treatment of a liquid-crystal polyester resin molding with a metal, a precision fine-line circuit (having a line width of 0.25mm or below and a space width of 0.25mm or below) can be produced by the substractive method. The surface layer of the product is not easily peeled off. The product has a uniform, dense surface structure. The adhesion of the metallic coating to the surface is increased. The problem of peeling at a high temperature which is caused by a difference in the thermal expansion coefficient between the resin and the metal is solved, though the inhibition of the peeling has been difficult when an ordinary thermoplastic resin is used. Dipping in a soldering bath (time: about 10 sec.) is also possible. Thus the process of the present invention can be applied not only to a material for exterior parts by also to the fields related to printed circuit boards.

## Examples

The following non-limiting Examples will further illustrate the present invention.

### Examples 1 to 14 and Comparative Examples 1 to 6

One of liquid-crystal polyester resins A to F which will be described below was kneaded together with a filler listed in Table 1 in amounts specified in Table 1 (expressed in terms of % by weight based on the whole composition) by melt blending with an extruder to form pellets. The pellets were dried at 140°C for 3 h and molded into flat plates having a size of 50mm x 70mm x 3mm with a moulding machine having a mold heated to 100 to 160°C.

The flat plates (base plates) thus formed were subjected to surface metal coating treatments at various plate temperatures by the following methods:

1) vacuum deposition: the above plate was placed in a treatment chamber of a vacuum deposition apparatus (EX 500; mfd. by ULVAC Corporation) and the chamber was evacuated to 533 μPa (4 x $10^{-6}$ Torr).

The surface temperature of the molding was adjusted to a predetermined value with a halogen lamp for heating the molding placed in the chamber. Metallic copper was evaporated with electron beams to form a thin metallic copper coating (thickness: 3 to 5μm) on the surface of each plate. After the completion of the deposition, the formed board was cooled and taken out.

2) Sputtering: the molding was placed in a treatment chamber of a sputtering apparatus (8ES: mfd. by Tokuda Seisakujo Ltd. ,). After evacuation to 400 μPa (3 x $10^{-6}$ Torr), argon gas was introduced into the chamber and the equilibrium pressure was adjusted to 667 mPa (5 x $10^{-3}$ Torr). After the plate temperature was adjusted to a predetermined value with a halogen lamp, the plate was rotated at 10 rpm and the molding set on the plate was subjected to sputtering with a metallic copper target 100 mm distant from the plate to form a thin metallic copper coating.

3) Ion plating: a treatment chamber of an arc discharge-type ion plating apparatus (AIF-850 SB; manufactured by Shinko Seiki Co. Ltd.) was evacuated to 400 μPa (3 x $10^{-6}$ Torr). The temperature of the molding on the plate set in the chamber was adjusted to a predetermined value and a thin metallic copper coating was formed thereon by ion plating. The ionization current was was 100 mA and vacuum deposition rate was 0.5 μm/min.

Immediately after the surface treatment with the metal, the plate was electroplated with copper to form a metallic coating having a thickness of 30 to 40μm, since the peeling strength of the plate <u>per se</u> cannot be determined. It was cut into strips having a width of 5mm with a knife and the peeling strength of the strip was measured with a spring scale. The peeling rate was 50 mm/min. The results are shown in Table 1.

The liquid-crystal polyesters A to F used in the Examples comprised the following structural units :

A : 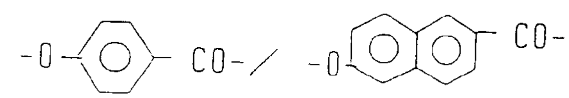 = 70/30

B : 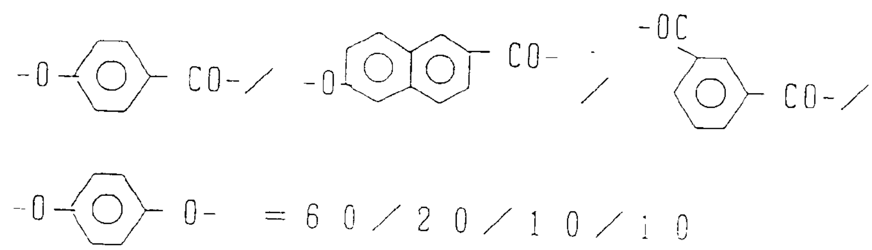 = 60/20/10/10

C : 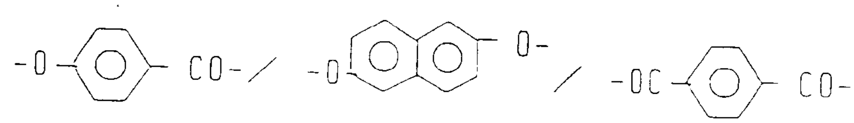

= 60/20/20

D : 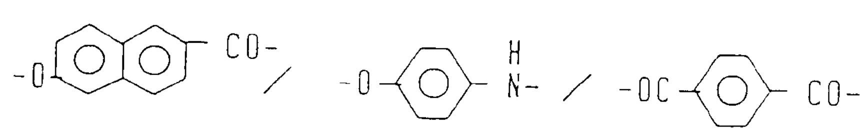

= 70/15/15

E : 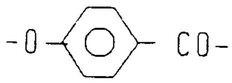 / 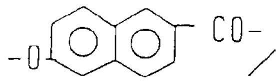 / 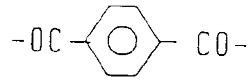

= 70 / 26 / 4

F : 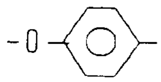 / 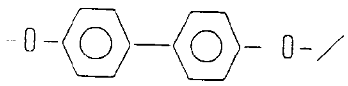 / 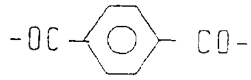 /

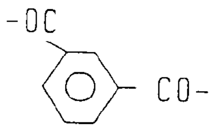 = 65 / 15 / 15 / 5

(The numerals represent the molar ratio)

Table 1

| Example No. or Comparative Example No. | Material | | | Surface treatment with metal and plate temp. (°C) | | | Adhesion of metallic coating (peeling strength) kg/cm |
|---|---|---|---|---|---|---|---|
| | polymer | filler (1) | filler (2) | vacuum deposition | sputtering | ion plating | |
| Comp. Ex. 1 | A (50) | milled fiber (50) | - | 30 | - | - | 0.10 |
| Comp. Ex. 2 | A (50) | ditto (15) | calcium pyrophosphate (35) | 30 | - | - | 0.15 |
| Comp. Ex. 3 | A (50) | ditto (50) | - | 50 | - | - | 0.20 |
| Comp. Ex. 4 | A (50) | ditto (15) | calcium pyrophosphate (35) | 50 | - | - | 0.25 |
| Ex. 1 | A (50) | ditto (50) | - | 200 | - | - | 1.00 |
| Ex. 2 | A (50) | ditto (15) | calcium pyrophosphate (35) | 200 | - | - | 1.10 |
| Ex. 3 | A (50) | ditto (15) | ditto (35) | 250 | - | - | 1.20 |
| Ex. 4 | A (40) | glass fiber (30) | wollastonite (30) | 200 | - | - | 1.05 |
| Ex. 5 | A (70) | potassium titanate whisker (30) | - | 200 | - | - | 1.10 |
| Ex. 6 | A (40) | calcium sulfate whisker (30) | zinc oxide (30) | 200 | - | - | 1.10 |
| Ex. 7 | A (80) | mica (20) | - | 200 | - | - | 1.00 |
| Comp. Ex. 5 | A (50) | milled fiber (50) | - | - | 40 | - | 0.25 |
| Ex. 8 | A (50) | ditto (50) | - | - | 200 | - | 1.05 |
| Comp. Ex. 6 | A (50) | ditto (50) | | - | - | 40 | 0.30 |
| Ex. 9 | A (50) | ditto (50) | - | - | - | 200 | 1.20 |
| Ex. 10 | B (50) | ditto (50) | - | 200 | - | - | 1.05 |
| Ex. 11 | C (50) | ditto (50) | - | 200 | - | - | 1.10 |
| Ex. 12 | D (50) | ditto (50) | - | 200 | - | - | 1.10 |
| Ex. 13 | E (50) | ditto (50) | - | 200 | - | - | 1.05 |
| Ex. 14 | F (50) | ditto (50) | - | 200 | - | - | 1.15 |

## Claims

1. A process for producing a metal-coated board suitable for the formation of a precision fine-line circuit by the substractive method, wherein a base plate of said board is prepared by molding a melt-processable liquid-crystal polyester resin composition containing an inorganic filler, and a metal surface coating is applied directly to the molded base plate by sputtering ion plating or vacuum deposition while heating the surface of said plate to a temperature of 60°C to 270°C in a reduced-pressure chamber.

2. A process according to claim 1, wherein the inorganic filler (B) includes one or more finely pulverised inorganic fillers selected from the group consisting of the Group II elements of the periodic table and their oxides, sulphates, phosphates, silicates and carbonates or the group consisting of aluminium, silicon, tin, lead, antimony and bismuth elements and their oxides and the amount of the said pulverised inorganic filler(s) is 5 to 80% by weight, based on the total weight of the polyester composition.

3. A process according to claim 2, wherein the inorganic filler (B) includes one or more finely pulverised inorganic fillers having an average particle diameter in the range of 0.01 to 100μm.

4. A process according to any preceding claim, wherein the inorganic filler (B) includes a fibrous inorganic filler having a diameter of 1 to 30μm and a length of 5μm to 1mm, and the amount of the said fibrous inorganic filler is 1 to 60% by weight, based on the total weight of the polyester composition.

5. A process according to claim 4, wherein the fibrous inorganic filler is selected from glass fiber, milled glass fiber and potassium titanate fiber.

6. A process according to any one of claims 2 to 5, wherein the inorganic filler (B) is a combination of the finely pulverized inorganic filler(s) and the fibrous inorganic filler(s) and the total amount of the inorganic filler is 85% by weight, based on the total weight of the polyester composition.

7. A process according to any preceding claims, wherein the base plate is molded by a molding means selected from among injection molding, extrusion molding and compression molding.

## Patentansprüche

1. Verfahren zur Herstellung einer metallbeschichteten Leiterplatte, die zur Bildung einer Präzisions-Feinlinien-Schaltung nach dem subtraktiven Verfahren geeignet ist, worin eine Grundplatte dieser Leiterplatte durch Formen einer in der Schmelze verarbeitbaren flüssig-kristallinen Polyesterharz-Zusammensetzung, die einen anorganischen Füllstoff enthält, hergestellt wird, und eine Metalloberflächen-Beschichtung direkt auf die geformte Grundplatte durch Zerstäuben, Ionen-Schichtabscheidung oder Vakuum-Abscheidung unter Erhitzen der Oberfläche dieser Platte auf eine Temperatur von 60 °C bis 270 °C in einer Unterdruckkammer aufgebracht wird.

2. Verfahren gemäß Anspruch 1, worin der anorganische Füllstoff (B) einen oder mehrere fein pulverisierte anorganische Füllstoffe umfaßt, ausgewählt aus der Gruppe bestehend aus Elementen der Gruppe II des Periodensystems und ihren Oxiden, Sulfaten, Phosphaten, Silicaten und Carbonaten oder der Gruppe bestehend aus Aluminium-, Silicium-, Zinn-, Blei-, Antimon- und Wismuth-Elementen und ihren Oxiden und wobei die Menge des(r) pulverisierten anorganischen Füllstoffs(e) 5 bis 80 Gew.-% bezogen auf das Gesamtgewicht der Polyester-Zusammensetzung beträgt.

3. Verfahren gemäß Anspruch 2, worin der anorganische Füllstoff (B) einen oder mehrere fein pulverisierte anorganische Füllstoffe mit einem durchschnittlichen Teilchendurchmesser im Bereich von 0,01 bis 100 μm umfaßt.

4. Verfahren gemäß irgendeinem der vorhergehenden Ansprüche, worin der anorganische Füllstoff (B) einen faserigen anorganischen Füllstoff eines Durchmessers von 1 bis 30 μm und einer Länge von 5 μm bis 1 mm umfaßt, und die Menge des faserigen anorganischen Füllstoffs 1 bis 60 Gew.-% bezogen auf das Gesamtgewicht der Polyester-Zusammensetzung beträgt.

5. Verfahren gemäß Anspruch 4, worin der faserige anorganische Füllstoff aus Glasfaser, gemahlener Glasfaser und Kaliumtitanat-Faser ausgewählt ist.

6. Verfahren gemäß irgendeinem der Ansprüche 2 bis 5, worin der anorganische Füllstoff (B) eine Kombination aus dem(n) fein pulverisierten anorganischen Füllstoff(en) und dem(n) faserigen anorganischen Füllstoff(en) ist und die Gesamtmenge des anorganischem Füllstoffs 85 Gew.-% bezogen auf das Gesamtgewicht der Polyester-Zusammensetzung beträgt.

7. Verfahren gemäß irgendeinem der vorhergehenden Ansprüche, worin die Grundplatte durch ein Formverfahren ausgewählt aus Spritzgießen, Strangpressen und Formpressen geformt wird.

## Revendications

1. Un procédé de fabrication de cartes métallisées convenant à la réalisation de circuits de précision à conducteurs fins par le procédé soustractif, dans lequel une plaque de base de ladite carte est préparée en moulant une composition de résine de polyester, à cristaux liquides façonnable au fondu contenant une charge minérale, et un revêtement métallique superficiel est appliqué directement sur la plaque de base moulée par métallisation au vide, plaquage ionique ou déposition sous vide tout en chauffant la surface de ladite plaque à une température de 60° C à 270° C dans une chambre sous pression réduite.

2. Un procédé selon la revendication 1, dans lequel la charge minérale (B) comprend une ou plusieurs charges minérales finement pulvérisées choisies parmi le groupe constitué des éléments du Groupe II du tableau périodique et de leurs oxydes, sulfates, phosphates; silicates et carbonates ou du groupe composé des éléments aluminium, silicium, étain, plomb, antimoine et bismuth et de leurs oxydes et la quantité de ladite / desdites charges minérales pulvérisées est de 5 à 80 pour cent en poids par rapport au poids total de la composition de polyester.

3. Un procédé selon la revendication 2 dans lequel la charge minérale (B) comprend une ou plusieurs charges minérales finement pulvérisées ayant un diamètre moyen de particules de l'ordre de 0,01 à 100 $\mu$m.

4. Un procédé selon l'une quelconque des revendications précédentes, dans lequel la charge minérale (B) comprend une charge minérale fibreuse ayant un diamètre de 1 à 30 $\mu$m et une longueur de 5 $\mu$m à 1 mm, et la quantité de ladite charge minérale fibreuse est de 1 à 60 pour cent en poids par rapport au poids total de la composition de polyester.

5. Un procédé selon la revendication 4 dans lequel la charge minérale fibreuse est choisie parmi la fibre de verre, la fibre de verre broyée et la fibre de titanate de potassium.

6. Un procédé selon l'une quelconque des revendications 2 à 5, dans lequel la charge minérale (B) est une combinaison de la ou des charges minérales finement pulvérisées et de la ou des charges minérales fibreuses et la quantité totale de la charge minérale est de 85 pour cent en poids par rapport au poids total de la composition de polyester.

7. Un procédé selon l'une quelconque des revendications précédentes, dans lequel la plaque de base est moulée par un moyen de moulage choisi parmi le moulage par injection, le moulage par extrusion et le moulage par compression.